# EUROPÄISCHE PATENTSCHRIFT

(11) **EP 2 561 531 B1**
(45) Veröffentlichungstag und Bekanntmachung des Hinweises auf die Patenterteilung: **08.06.2016**
(21) Anmeldenummer: 11714042.6
(22) Anmeldetag: 13.04.2011
(51) Int. Cl.: H01H 1/58, H02B 1/20, H05K 1/14

(54) **EINSPEISEMODUL**
POWER SUPPLY MODULE
MODULE D'ALIMENTATION

(30) Priorität: 19.04.2010 DE 102010027901
(43) Veröffentlichungstag der Anmeldung: 27.02.2013
(73) Patentinhaber: Beckhoff Automation GmbH, 33415 Verl (DE)
(72) Erfinder: EICKHOFF-GÖTZA, Markus, 33378 Rheda-Wiedenbrück (DE); SIEWEKE, Frank, 33818 Leopoldshöhe (DE); MISCHE, Christian, 33699 Bielefeld (DE)
(74) Vertreter: Patentanwaltskanzlei WILHELM & BECK
(86) Internationale Anmeldenummer: PCT/EP2011/055767
(87) Internationale Veröffentlichungsnummer: WO 2011/131527

(56) Entgegenhaltungen:
- DE-A1- 10 040 651
- DE-U1-202010 004 061
- US-A- 4 989 118
- US-A1- 2008 268 671

## Beschreibung

Die Erfindung betrifft ein Einspeisemodul zur Einspeisung von elektrischem Strom in ein Antriebsmodul, wobei das Einspeisemodul einen ersten Anschlussköntakt und einen zweiten Anschlusskontakt aufweist, wobei der erste Anschlusskontakt ausgelegt ist, das Einspeisemodul mit dem Antriebsmodul zu verbinden, und der zweite Anschlusskontakt ausgelegt ist, eine Verbindung zu einer Stromversorgung bereitzustellen.

Es sind Antriebssysteme mit einem Antriebsmodul, einem Einspeisemodul und einer Verbindung zu einer Steuereinheit bekannt, wobei das Einspeisemodul mit dem Antriebsmodul und einer Stromversorgung verbunden ist. Das Antriebsmodul steuert dabei einen Motor an und stellt dieser die Stromversorgung bereit.

Gemäß "UL Standard for Safety for Industrial Control Panels, UL 508A" ist es erforderlich, dass Antriebsmodule jeweils separat mit Sicherungselementen gegen ein Überschreiten eines vorgegebenen maximalen Stroms abgesichert sind. Üblicherweise werden die Sicherungselemente in dem Antriebsmodul angeordnet, wobei die Sicherungselemente an einen mit dem Antriebsmodul verbundenen Motor angepasst sind. Dies erfordert jedoch eine entsprechende konstruktive Anpassung des Antriebsmoduls an die Erfordernisse des UL-Standards, sowie an den am Antriebsmodul angeschlossenen Motor.

Aus der US 2008/268671 A1 ist ein Sicherungsverteilerkasten bekannt, über den Strom eingespeist werden kann, wobei zwei Leiterkarten vorgesehen sind, auf denen jeweils Anschlüsse angeordnet sind. Zwischen den Anschlüssen sind dann die Sicherungselemente geschaltet, die wiederum auf der einen Leiterplatte angeordnet sind, um den Stromfluss zwischen den Anschlusskontakten zu begrenzen.

Die US 4 989 118 zeigt einen Stromunterbrecher, bei dem mehrere Stromunterbrecher über eine Schiene zusammen verbunden werden könnten.

Es ist daher Aufgabe der Erfindung, eine vereinfachte Abscherung eines Antriebsmoduls bereitzustellen.

Diese Aufgabe wird durch ein Einspeisemodul gemäß Anspruch 1 gelöst. Weitergehende Ausführungsformen sind in den abhängigen Ansprüchen angegeben.

Erfindungsgemäß wurde erkannt, dass ein verbessertes Einspeisemodul dadurch bereitgestellt werden kann, dass das Einspeisemodul einen ersten Anschlusskontakt und einen zweiten Anschlusskontakt aufweist, wobei der erste Anschlusskontakt das Einspeisemodul mit dem Antriebsmodul verbindet und der zweite Anschlusskontakt eine Verbindung zu einer Stromversorgung bereitstellt, wobei zwischen dem ersten Anschlusskontakt und dem zweiten Anschlusskontakt ein Sicherungselement angeordnet ist, das mit den beiden Anschlusskontakten verbunden ist und einen Stromfluss zwischen dem ersten Anschlusskontakt und dem zweiten Anschlusskontakt begrenzt.

Auf diese Weise wird gewährleistet, dass ein Antriebsmodul ohne konstruktive Umbauten zuverlässig gegen eine Überstromung abgesichert ist. Ferner kann auf diese Weise das Antriebsmodul entsprechend verschiedener unterschiedlicher Standards modular durch das Sicherungselement abgesichert werden.

In einer weiteren Ausführungsform der Erfindung ist der erste Anschlusskontakt auf einer ersten Leiterkarte und der zweite Anschlusskontakt auf einer zweiten Leiterkarte angeordnet, wobei zwischen der ersten Leiterkarte und der zweiten Leiterkarten das Sicherungselement angeordnet und mit den Leiterkarte verbunden ist. Auf diese Weise können die Sicherungselemente einfach in dem Einspeisemodul befestigt werden.

In einer weiteren Ausführungsform der Erfindung weist der zweite Anschlusskontakt einen Kontaktschieber mit einem Kontaktschieber und einer Kontaktbrücke auf, die vom Kontaktschieber betätigt wird und in ein weiteres Einspeisemodul eingreift, um eine elektrische Verbindung zu dem weiteren Einspeisemodul bereitzustellen. Auf diese Weise kann einfach und schnell eine Verbindung von dem Einspeisemodul zu einem weiteren Einspeisemodul erstellt werden, was insbesondere bei der Zusammenstellung von einer Mehrzahl von Antriebsmodulen zu einem Mehrachsantriebssystem von Vorteil ist.

In einer weiteren Ausführungsform der Erfindung ist das Sicherungselement mit einer Stromschiene verbunden, die mit einer der beiden Leiterkarten verbunden ist und eine elektrische Verbindung von dem Sicherungselement zu einer der beiden Leiterkarten bereitstellt. Mittels der Stromschiene können sicher hohe Ströme von der Leiterkarte zu dem Sicherungselement geleitet werden.

In einer weiteren Ausführungsform der Erfindung ist die Stromschiene Z-förmig ausgebildet und verbindet eine Platte mit einer der beiden Leiterkarten. Auf diese Weise kann die räumliche Anordnung der Platte innerhalb eines Gehäuses des Einspeisemoduls einfach festgelegt werden.

In einer weiteren Ausführungsform der Erfindung umfasst das Sicherungselement einen Sicherungskörper und einen Sicherungshalter, wobei der Sicherungshalter ah der Platte befestigt und mit der Stromschiene verbunden ist, und wobei der Sicherungshalter den Sicherungskörper im Gehäuse des Einspeisemoduls befestigt. Auf diese Weise wird eine vibrationsfeste Befestigung des Sicherungskörpers im Einspeisemodul bereitgestellt.

In einer weiteren Ausführungsform der Erfindung ist die erste Leiterkarte mit der zweiten Leiterkarte mittels eines Verbindungsbolzens verbunden. Auf diese Weise können einfach die beiden Leiterkarten gegeneinander abgestützt werden sowie vom ersten Anschlusskontakt zum zweiten Anschlüsskontakt eine Verbindung ohne Sicherungselement bereitgestellt werden.

In einer weiteren Ausführungsform der Erfindung weist das Gehäuse des Einspeisemoduls einen ersten, einen zweiten und einen dritten Gehäuseteil auf, wobei der erste Gehäuseteil sowohl mit dem zweiten als auch mit dem dritten Gehäuseteil verbindbar ist. Auf diese Weise ist gewährleistet, dass die drei Gehäuseteile zusammen ein erstes Gehäuse ausbilden können, wobei mittels des ersten Gehäuseteils und des dritten Gehäuseteils ein zweites Gehäuse ausbildbar ist, welches als Einspeisemodul ohne Sicherungselement ausgebildet ist.

In einer weiteren Ausführungsform der Erfindung ist der zweite Gehäuseteil zwischen dem ersten und dem dritten Gehäuseteil angeordnet, wobei der erste Gehäuseteil einen ersten zinnenförmig ausgebildeten Bereich umfasst, der dem zweiten Gehäuseteil zugewandt ist. Der zweite Gehäuseteil umfasst einen zweiten zinnenförmige Bereich, der derart ausgebildet ist, dass der zweite zinnenförmige Bereich in den ersten zinnenförmigen Bereich eingreift. Auf diese Weise wird gewährleistet, dass Öffnungen, die mittels des ersten zinnenförmigen Bereichs des ersten Gehäuseteils und dem dritten Gehäuseteil ausgebildet werden, bei dem Einspeisemodul mit drei Gehäuseteilen zuverlässig verschlossen werden.

In einer weiteren Ausführungsform der Erfindung weist das Gehäuse einen Deckel auf, der in einem Bereich des Sicherungselements seitlich am Gehäuse angeordnet ist, wobei der Deckel von außen zu öffnen und wieder verschließbar ist und das Sicherungselement abdeckt. Auf diese Weise wird gewährleistet, dass die stromführenden Sicherungen zuverlässig gegen externen Angriff von außen abgesichert sind, wobei durch die seitliche Anordnung des Deckels am Gehäuse der Monteur gezwungen ist, das Einspeisemodul vom Antriebsmodul zu trennen, um das Sicherungselement wechseln zu können. Dies gewährleistet zuverlässig, dass das Sicherungselement während des Wechsels stromfrei ist.

In einer weiteren Ausführungsform der Erfindung ist in dem Einspeisemodul ein Lüfter angeordnet ist, der ausgelegt ist, Kühlluft durch das Einspeisemodul zu fördern. Auf diese Weise kann eine Betriebstemperatur der Sicherungselemente durch eine Zwangskühlung mittels des Lüfters sichergestellt werden.

Nachfolgend wird die Erfindung anhand von Figuren näher erläutert. Dabei zeigen:
Figur 1 eine perspektivische Ansicht eines ersten Einspeisemoduls an einem Antriebsmodul im montierten Zustand;
Figur 2 eine Vorderansicht des ersten Einspeisemoduls;
Figur 3 eine Vorderansicht des ersten Einspeisemoduls mit einem demontierten ersten Gehäuseteil;
Figur 4 eine Seitenansicht des ersten Einspeisemoduls;
Figur 5 eine perspektivische Ansicht des ersten Einspeisemoduls;
Figur 6 eine perspektivische Ansicht des ersten Einspeisemoduls in teilmontiertem Zustand;
Figur 7 eine perspektivische Ansicht des ersten Einspeisemoduls 10; und
Figur.8 eine perspektivische Ansicht eines zweiten Einspeisemoduls.

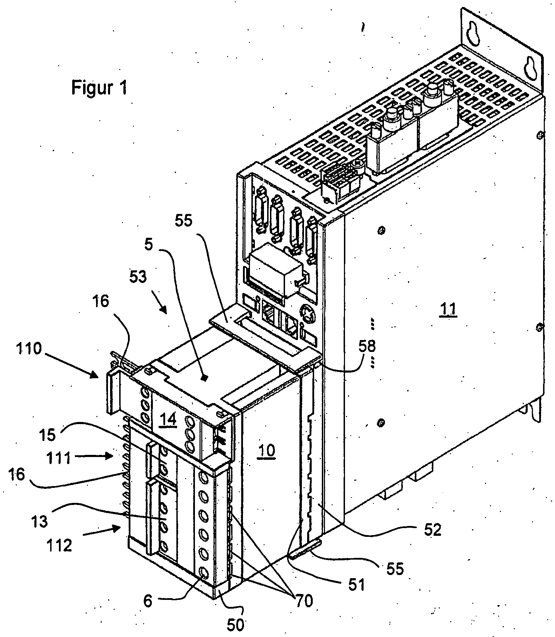

Figur 1 zeigt eine perspektivische Ansicht eines ersten Einspeisemoduls 10 an einem Antriebsmodul 11 im montierten Zustand. Das Antriebsmodul 11 ist als Servoverstärker ausgebildet und dient zur Ansteuerung eines nicht dargestellten Servomotors. An einer Vorderseite des Antriebsmoduls 11 ist das Einspeisemodul 10 angeordnet. Das erste Einspeisemodul 10 umfasst ein Gehäuse 53, an dessen Vorderseite mehrere Kontaktschieber 13, 14, 15 angeordnet sind, die die Anschlusskontakte 110, 111, 112 des ersten Einspeisemoduls bilden. Die Kontaktschieber 13, 14, 15 umfassen Kontaktbrücken 16 , wobei die Kontaktschieber 13, 14, 15 nach links und rechts an der Vorderseite des ersten Einspeisemoduls 10 verschoben werden können. Ferner weisen die Kontaktschieber 13, 14, 15 mehrere Verschraubungsöffnungen 6 auf. Das Gehäuse 53 des ersten Einspeisemoduls 10 ist dreiteilig ausgebildet und umfasst ein erstes Gehäuseteil 50, an dem die Kontaktschieber 13, 14, 15 angeordnet sind, ein zweites Gehäuseteil 51 und ein drittes Gehäuseteil 52, wobei das zweite Gehäuseteil 51 zwischen dem. ersten Gehäuseteil 50 und dem dritten Gehäuseteil 52 angeordnet ist.

Im rechtsseitigen.Bereich des Gehäuses 53 im Übergangsbereich des ersten Gehäuseteils 50 zum zweiten Gehäuseteil 51 umfasst das Gehäuse 53 ferner mehrere Kontaktöffnungen 70, die zur Aufnahme der Kontaktbrücken 16 eines weiteren Einspeisemoduls ausgelegt sind. Rückseitig weist das Gehäuse 53 ein Rastelement 55 auf, das in eine Rastnase 58 des Antriebsmoduls 11 eingreift.

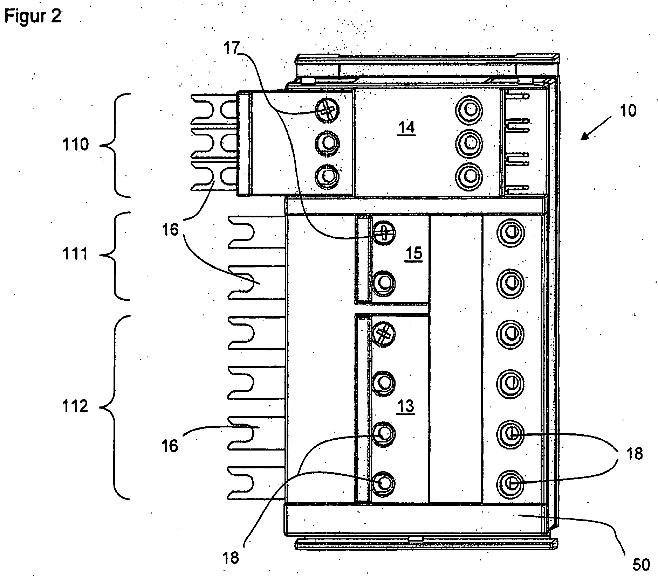

Figur 2 zeigt eine Vorderansicht des ersten Einspeisemoduls 10. Die Kontaktschieber 13, 14, 15 sind in einem ausgefahrenen, betätigten Zustand dargestellt, bei welchem die Kontaktbrücken 16 aus dem Gehäuse 53 des ersten Einspeisemoduls 10 ragen, um in ein weiteres Einspeisemodul einzugreifen und Kontaktelemente 19 eines weiteren Einspeisemoduls zu kontaktieren. Um das erste Einspeisemodul 10 an dem Antriebsmodul 11 zu montieren, werden die Kontaktschieber 13, 14, 15 nach rechts verschoben, so dass die Kontaktbrücken 16 im Gehäuse 53 des ersten Einspeisemoduls 10 eingeschoben sind. Wird das Einspeisemodul 10 in einem Verbund mit mehreren Antriebsmodulen und weiteren Einspeisemodulen montiert, so wird das Einspeisemodul 10 auf das Antriebsmodul 11 aufgesteckt, wobei die Rastelemente 55 in Rastnasen 58 des Antriebsmoduls 11 eingreifen und das erste Einspeisemodul 10 reversibel am Antriebsmodul 11 befestigt. Um einen zuverlässigen Kontakt zu den weiteren Einspeisemodulen zu gewährleisten, werden die Kontaktschieber 13, 14 , 15 nach einer Verrastung des ersten Einspeisemoduls 10 am Antriebsmodul 11 nach links verschoben, so dass die Kontaktbrücken 16 in ein weiteres Einspeisemodul hinein ragen und dort in nicht dargestellte Kontaktelemente eingreifen.

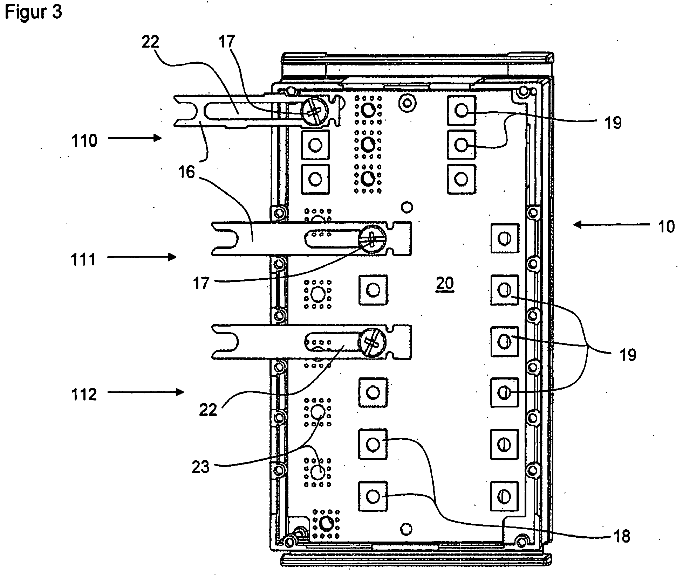

Figur 3 zeigt die in Figur 2 dargestellte Vorderansicht des ersten Einspeisemoduls 10 ohne das erste Gehäuseteil 50, welches die Kontaktschieber 13,14,15 trägt. Auf einer ersten Leiterkarte 20, die parallel zur Zeichenebene angeordnet ist, sind mehrere Schraubenaufnahmen 18 mit Befestigungsschrauben 17 angeordnet. Die Kontaktbrücken 16, von denen.hier nur ein Teil dargestellt sind, umfassen jeweils ein Langloch 22, das in Richtung der Längsachse der Kontaktbrücken 16 angeordnet ist. Zur Befestigung der Kontaktbrücken 16 durchgreifen die Befestigungsschrauben 17 die Langlöcher 22 der Kontaktbrücken 16 und befestigen diese an der ersten Leiterkarte 20. Die Kontaktbrücken 16 können durch die Kontaktschieber 13, 14, 15 verschoben werden, wobei in dem Langloch 22 die Befestigungsschraube 17 zum Verschieben gelöst ist. Um ein vibrationsfestes Kontaktieren über die Kontaktschieber 13, 14, 15 zu gewährleisten, wird durch die Verschraubungsöffnungen 6 die Befestigungsschraube 17 angezogen, so dass die Kontaktbrücke 16 zuverlässig befestigt ist. Dies erlaubt eine schnelle Montage und Demontage des ersten Einspeisemoduls 10.

Die erste Leiterkarte 20 weist ferner Befestigungspunkte 23 auf, die zur Verbindung der ersten Leiterkarte 20 mit einer dahinter angeordneten zweiten Leiterkarte 21 dienen. Rechtsseitig sind an der ersten Leiterkarte 20 mehrere Kontaktelemente 19 angeordnet, in die die Kontaktbrücke 16 eines weiteren Einspeisemoduls eingreifen können, um so eine Verbindung zu dem weiteren Einspeisemodul bereitzustellen.

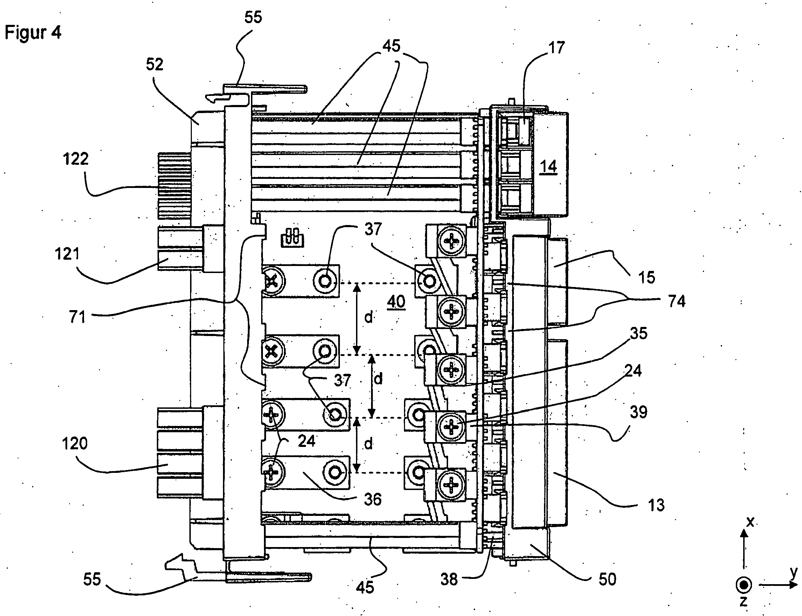

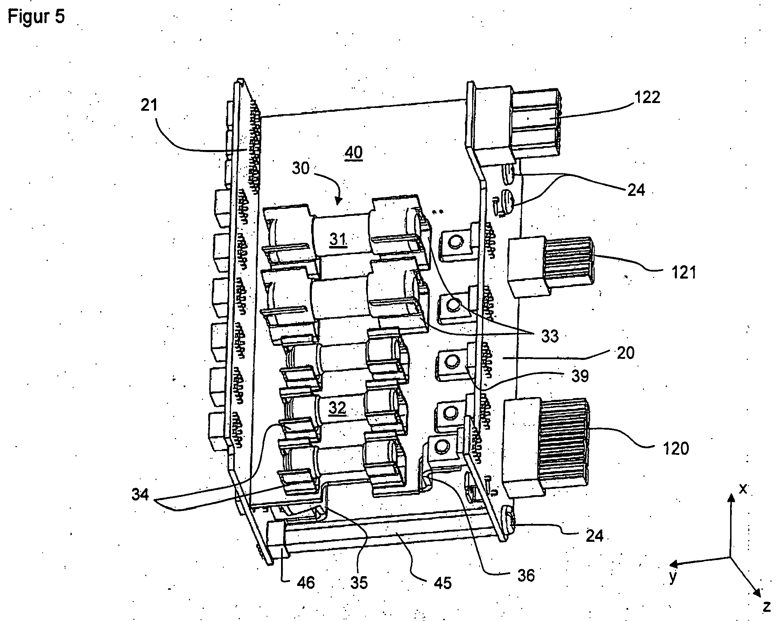

Figur 4 zeigt eine Seitenansicht des ersten Einspeisemoduls 10 in teilmontiertem Zustand. Im Gehäuse 53 des ersten Einspeisemoduls 10 sind gegenüber liegend am ersten Gehäuseteil 50 die erste Leiterkarte 20 und am dritten Gehäuseteil 52 parallel zur ersten Leiterkarte 20 eine zweite Leiterkarte 21 angeordnet. Dabei wird in der Figur 4 die zweite Leiterkarte 21 durch das dritte Gehäuseteil 52 verdeckt. Die Leiterkarten 20, 21 sind parallel zur Vorder- und Rückseite des Gehäuses 53 angeordnet und im Gehäuse 53 mittels Befestigungselementen 38 befestigt. Senkrecht zu den beiden Leiterkarten 20, 21 ist eine Platte 40 angeordnet, die elektrisch isolierendes Material aufweist und zur Befestigung der Stromschienen 35, 36 sowie der auf der gegenüberliegenden Seite der Platte 40 angeordneten und in Figur 5 dargestellten Sicherungselemente 30 dient.

Eine an der ersten Leiterkarte 20 angeordnete erste Stromschiene 35 ist Z-förmig ausgebildet und ist an einem Ende mit einem Winkelelement 39 mittels einer Verbindungsschraube 24 befestigt. Am anderen Ende weist die erste Stromschiene 35 eine Aufnahme 37 auf. Die Z-förmige Ausbildung der ersten Stromschiene 35 dient dazu, einen Sicherheitsabstand d zwischen den Stromschienen 35, 36 und den Sicherungselementen 30 festzulegen. Auf diese Weise wird gewährleistet, dass der für Luft notwendige Sicherheitsabstand d korrespondierend zu einer am Sicherungselement 30 anliegenden Spannung und zur Isolation des Sicherungselements 30 eingehalten wird. Durch die Z-förmige Ausbildung kann dabei die Aufnahme 37 zur Befestigung des Sicherungselements 30 in der Höhe (x-Richtung) konstruktiv an der Platte 40 festgelegt werden, so dass der vorhandene Bauraum im Gehäuse 53 optimal ausgenutzt wird. Ferner wird durch die Z-förmige Ausbildung der ersten Stromschiene 35 die Bauraumtiefe in z-Richtung des Gehäuses 53 optimal ausgenutzt, um eine schmale Ausführung des Einspeisemoduls 10 zu gewährleisten.

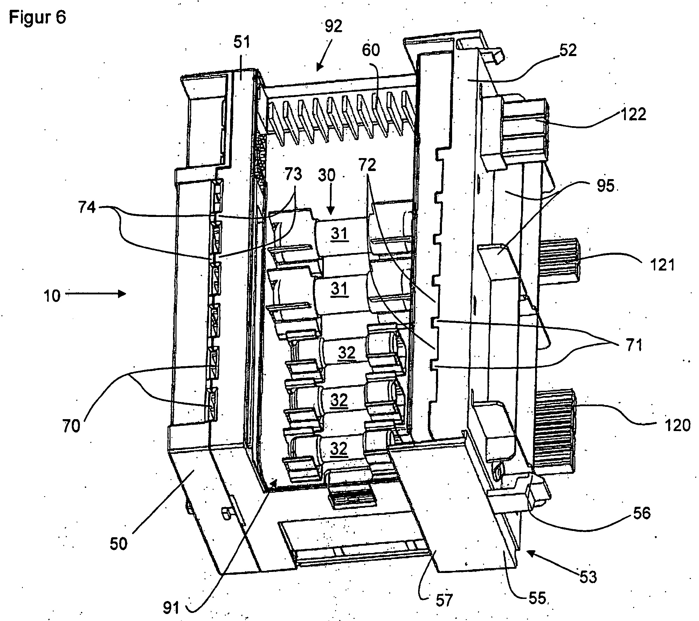

Eine zweite Stromschiene 36 ist plattenförmig ausgebildet und verbindet eine Ausgangsseite der Sicherungselemente 30 und die Aufnahme 37 mit der zweiten Leiterkarte 21. Die zweiten Stromschienen 36 sind an der zweiten Leiterkarte 21 mittels der Verbindungsschrauben 24 und nicht dargestellten Winkelelemente befestigt. Auf der Rückseite der Platte 40 sind, wie in Figur 5 und 6 gezeigt, die Sicherungselemente 30 angeordnet. Die Aufnahme 37 ist mit dem Sicherungselement 30 durch die Platte 40 elektrisch leitend verbunden. An der zweiten Leiterkarte 21 sind Anschlusskontakte 120, 121, 122 vorgesehen, um das erste Einspeisemodul 10 im montierten Zustand mit dem Antriebsmodul 11, wie in Figur 1 gezeigt, zu verbinden. Dabei stellt ein erster Anschlusskontakt 120 die über den ersten Kontaktschieber 13 abgegriffene Netzspannung zur Verfügung. Ein zweiter Anschlusskontakt 121 dient einem Zwischenkreisverbund zum Energieaustausch zwischen den einzelnen Antriebsmodulen 11. Eine Verbindung für den zweiten Anschlusskontakt 121 wird über den dritten Kontaktschieber 15 zu weiteren Einspeisemodulen bereitgestellt. Ein dritter Anschlusskontakt 122 ist mittels Verbindungsbolzen 45 mit dem zweiten Kontaktschieber 14 verbünden und stellt eine Hilfsspannung in Form von Gleichspannung zur Versorgung des Antriebsmoduls 11 oder zur Steuerung, z.B. einer Bremse, eines Thermokontakts und/oder.für digitale Ein- und Ausgänge, bereit. Aufgrund der niedrigen darin verlaufenden Steuerströme, ist eine Absicherung gemäß dem UL-Standard nicht vorgesehen. Ferner ist der dritte Anschlusskontakt 122 und der zweiten Kontaktschieber 14 durch den Verbindungsbolzen 45 widerstandsarm verbunden.

Figur 5 zeigt eine perspektivische Ansicht des ersten Einspeisemoduls 10. Dabei ist eine Rückseite der Figur 4 dargestellt. Auf der Platte 40 sind die Sicherungselemente 30 angeordnet. Die Sicherungselemente 30 weisen je nach abzusichernder Stromhöhe eine unterschiedliche Größe auf. So sind die ersten unterhalb angeordneten Sicherungskörper 32 zur Absicherung des ersten Anschlusskontakts 120 kleiner ausgebildet als die oberhalb der ersten Sicherungskörper angeordneten zweiten Sicherungskörper 3i zur Absicherung des Zwischenkreisverbundes. Entsprechend der Größe der Sicherungskörper 31, 32 sind die korrespondierenden Sicherungshalter 33, 34 ausgebildet und an der Platte 40 befestigt.

Die Sicherungshalter 33, 34 sind in x-Richtung derart auf der Platte 40 voneinander beabstandet, dass ein Üerschlagen von Spannungen zu den daneben angeordneten Sicherungshalter 33, 34 vermieden wird und ein für die anliegenden Spannungen notwendiger Sicherheitsabstand d eingehalten wird. Die Sicherungshalter 33, 34 greifen rückseitig in die Aufnahme 37 ein und sind dadurch mit den Stromschienen 35, 36 verbunden. Anstelle der dargestellten Schmelzsicherungen sind auch elektronische Sicherungen, selbstrückstellende Sicherungen, Motorschutzschalter oder Leistungsschutzschalter denkbar.

Die Verbindungsbolzen 45 sind mittels Verbindungsschrauben 24 an der ersten Leiterkarte 20 befestigt. An dem zur Verbindungsschraube 24 gegenüber liegenden Ende des Verbindungsbolzen 45 weist der Verbindungsbolzen 45 ein Gewinde auf, das in montiertem Zustand in eine Bolzenverschraubung 46, die innenseitig an der zweiten Leiterkarte 21 angeordnet ist, eingreift. Auf diese Weise kann bei der Montage der Verbindungsbolzen 45 einfach montiert werden, wobei ferner eine zuverlässige Stromübertragung von der ersten Leiterkarte 20 zur zweiten Leiterkarte 21 gewährleistet ist. Die oben und unten im Gehäuse angeordneten Verbindungsbolzen 45 stützen ferner die beiden Leiterkarten 20, 21 gegeneinander ab und befestigen diese zuverlässig im Gehäuse 53. Ferner ist die Platte 40 zur besseren Abstützung der Leiterkarten 20, 21 mit den Leiterkarten 20, 21 verbunden.

Die erste Stromschiene 35 ist ferner zusätzlich zur Z-förmigen Ausbildung S-förmig ausgebildet, um die Anordnung der Sicherungshalter 33, 34 auf der Platte 40 in y-Richtung bauraumtechnisch günstig anzuordnen. Dabei kann je nach Ausbildung der S-Form der Stromschiene 35 die Position der Platte in y-Richtung konstruktiv angepasst werden.

Figur 6 zeigt eine perspektivische Ansicht des Einspeisemoduls 10 in teilmontiertem Zustand. Die Anordnung der Leiterkarten 20, 21 entspricht der in Figur 5 gezeigten Ausführungsform des ersten Einspeisemoduls 10. Dabei ist das Gehäuse 53 des Einspeisemoduls 10 im Bereich der Sicherungselemente 30 geöffnet. Der dritte Gehäuseteil 52 umfasst einen ersten zinnenförmigen Bereich 72, der dem zweiten Gehäuseteil 51 zugewandt ist. Der zweite Gehäuseteil 51, der zwischen dem ersten Gehäuseteil 50 und dem dritten Gehäuseteil 52 angeordnet ist, weist einen zweiten zinnenförmigen Bereich 71 auf, der dem ersten zinnenförmigen Bereich 72 des dritten Gehäuseteils 52 zugewandt ist. Der zweite zinnenförmige Bereich 71 ist derart ausgebildet, dass der zweite zinnenförmige Bereich 71 in die Lücken des ersten zinnenförmigen Bereichs 72 eingreift und dieser die Struktur des ersten zinnenförmigen Bereichs 72 so abdeckt, dass das Gehäuse 53 in diesem Bereich gegenüber der Umwelt abgeschlossen ist.

Zwischen dem ersten Gehäuseteil 50 und dem zweiten Gehäuseteil 51 sind die. Kontaktöffnungen 70 angeordnet, in die die Kontaktbrücken 16 eines weiteren Einspeisemoduls in montiertem Zustand durchgeführt sein können. Die Kontaktöffnungen 70 werden durch einen dritten zinnenförmigen Bereich 73, der am zweiten Gehäuseteil 51 angeordnet ist und dem ersten Gehäuseteil 50 zugewandt ist, sowie durch einen vierten zinnenförmigen Bereich 74 des ersten Gehäuseteils 50, der dem zweiten Gehäuseteil 51 zugewandt ist, gebildet. Durch die Ausbildung der Gehäuseteile 50, 51, 52 mit den zinnenförmigen Bereichen 71, 72, 73, 74 können die Gehäuseteile 50, 51, 52 zur Ausbildung eines Einspeisemoduls 10 mit Sicherungselementen 30 verwendet werden. Die Ausbildung mit den zinnenförmigen Bereichen 71, 74 ermöglicht aber auch, dass das erste Gehäuseteil 50 an dem dritten Gehäuseteil 52 anordbar ist. In diesem Fall nehmen die Gehäuseteile 50, 52 jedoch keine Sicherungselemente 30 auf und bilden ein weiteres Einspeisemodul mit den Kontaktschiebern 13, 14, 15, das eine Stromversorgung des Antriebsmoduls 11 ohne Absicherung vorsieht. Dabei bilden der erste zinnenförmige Bereich 71 und der vierte zinnenförmige Bereich 74 die Kontaktöffnungen 70 aus.

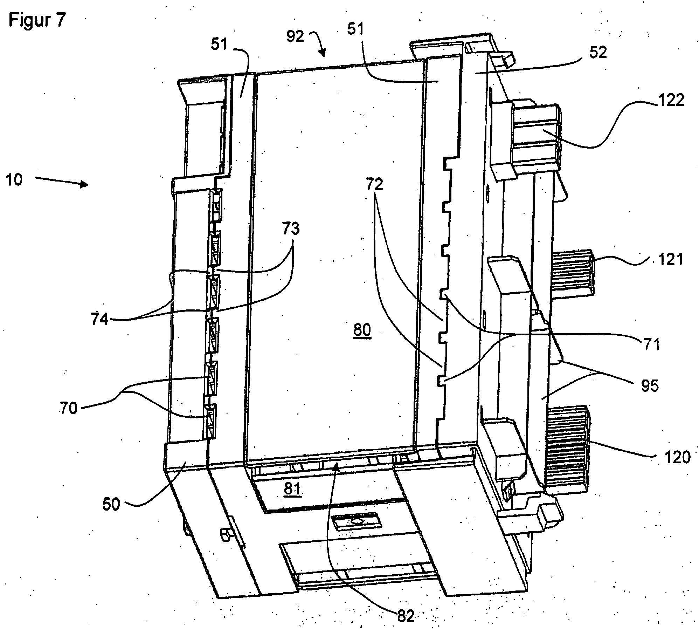

Oberhalb der Sicherungselemente 30 ist ein Lüftungsgitter 60 am zweiten Gehäuse 51 angeordnet, das einen Zugriff von oben durch eine erste Öffnung 92 auf die Sicherungselemente 30 verhindert und ferner die Durchströmung von Kühlluft durch das Gehäuse 53 ermöglicht. Die Kühlluft tritt dabei durch eine zweite Öffnung 91 in das Gehäuse 53 ein.und verlässt das Gehäuse 53 oberseitig beim Lüftungsgitter 60. Auf diese Weise kann eine Kühlung der Sicherungselemente 30 durch natürliche Konvektion gewährleistet werden. Alternativ wäre auch denkbar das Lüftungsgitter 60 an einem in Figur 7 gezeigten Deckel 80 innenseitig anzuordnen.
Das dritte Gehäuseteil 52 umfasst ferner seitlich angeordnete Rastelemente 55 mit einer Rastnocke 56 und einem Rastarm 57. Die Rastnocke 56 ist etwa in Richtung des Antriebsmoduls 11 ausgerichtet und umgreift dort in eine in Figur 1 dargestellte Rastnase 58. Die Rastnocke 56 kann durch den Rastarm 57 gelöst werden, um das Gehäuse 53 des Einspeisemoduls 10 vom Antriebsmodul 11 abziehen zu können. Auf diese Weise kann das Gehäuse 53, aber auch ein Einspeisemodul bestehend nur aus dem ersten und dritten Gehäuseteil 50, 52, reversibel am Antriebsmodul 11 befestigt werden.

Die dem Antriebsmodul 11 zugewandte Seite des dritten Gehäuseteils 52 umfasst mehrere Versteifungsrippen 95, die eine Verbindungssteifigkeit des dritten Gehäuseteils 52 gewährleisten, und so ein verbindungssteifes Einspeisemodul 10 sicherstellen.

Figur 7 zeigt eine perspektivische Ansicht des Einspeisemoduls 10 in montiertem Zustand. Unterhalb der in Figur 6 dargestellten Sicherungselemente 30 ist das Gehäuse 53 mittels einer Abdeckung 81 verschlossen, um so ein Berühren der stromführenden Sicherungselemente 30 von unten zu verhindern. Seitlich ist parallel zur Platte 40 am Gehäuse 53 ein Deckel 80 angeordnet, der die in Figur 5 und Figur 6 gezeigten Sicherungselemente 30 abdeckt. Zwischen der Abdeckung 81 und dem Deckel 80 ist ein Spalt 82 ausgebildet, der das Ausströmen von erwärmter Kühlluft aus dem Gehäuse 53 ermöglicht. Die seitliche Anordnung des Deckels 80 am zweiten Gehäuseteil 51 ermöglicht die sichere Abdeckung der Sicherungselemente 30 im stromführenden Zustand. Der Deckel 80 ist wieder verschieß. bar und von außen zu öffnen um defekte Sicherungselemente 30 tauschen zu können. Sollten mehrere Einspeisemodule 10 nebeneinander an verschiedenen Antriebsmodulen 11 montiert sein, so können defekte Sicherungselemente 30 nur dann gewechselt werden, wenn das Einspeisemodul 10 von weiteren Einspeisemodulen getrennt und vom Antriebsmodul 11 abgezogen wird. Auf diese Weise wird ein Zugriff auf die Sicherungselemente 30 ermöglicht, wobei die Sicherungselemente 30 durch das Abziehen des Einspeisemoduls 10 vom Antriebsmodul 11 und weiteren Einspeisemodulen 10 stromlos sind.

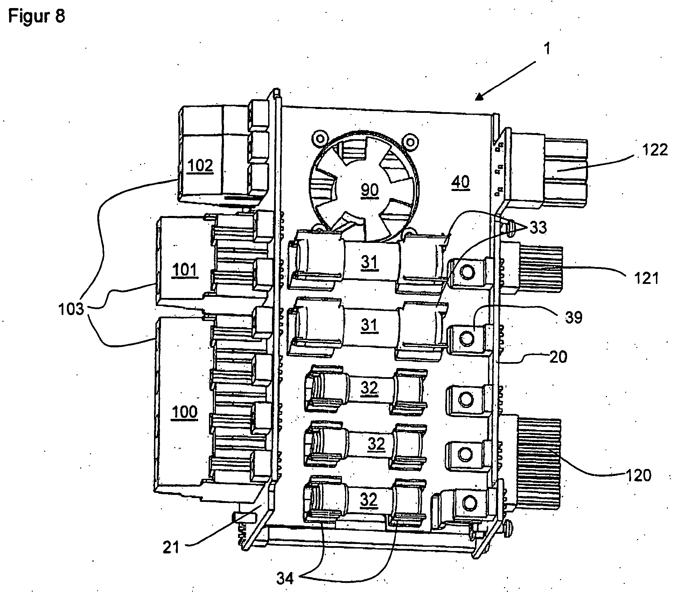

Figur 8 zeigt eine perspektivische Darstellung eines zweiten Einspeisemoduls 1. Das zweite Einspeisemodul 1 weist gegenüber dem in den Figuren 1 bis 7 gezeigten ersten Einspeisemodul 10 anstelle der als Kontaktschieber 13, 14, 15 ausgebildeten Anschlusskontakte 110, 111, 112 alternative Anschlusskontakte 100, 101, 102 auf, die dazu dienen, das zweite Einspeisemodul 1 mit nicht dargestellten An schlussleitungen zu verbinden. Die Anschlusskontakte 100, 101, 102 umfassen mehrere Anschlussöffnungen 103, in die jeweils ein Gegenstück des Anschlusskontakts 100, 101, 102 der Anschiussleitüng eingreift und eine elektrisch leitende Verbindung zu dem jeweiligen Kontakt des Anschlusskontakts 100, 101, 102 erstellt.

Ferner umfasst das zweite Einspeisemodul 1 einen Lüfter 90, der oberhalb der Sicherungselemente 30 angeordnet ist, um die Sicherungselemente 30 mit ausreichend Kühlluft zu versorgen. Dazu saugt der Lüfter 90 Kühlluft unterseitig des zweiten Einspeisemoduls 1 an. Die angesaugte Kühlluft wird an den Sicherungselementen 30 vorbeigeführt und verlässt als erwärmte Kühlluft, wie in Figur 1 bis Figur 7 gezeigt, das Gehäuse 53 oberseitig durch die erste Öffnung 92.

Das zweite Einspeisemodul 1 ist ausgelegt, mittels der Kontaktbrücken 16 des ersten Einspeisemoduls 10 eine elektrische Verbindung zu dem ersten Einspeisemodul 10 aufzubauen. Ferner stellen die Anschlusskontakte 120, 121, 122 an der dem Antriebsmodul 11 zugewandten Seite eine Verbindung zu dem Antriebsmodul 11 bereit. Die Sicherungselemente 30 des zweiten Einspeisemoduls 1 sind ebenso wie die in Figur 1 bis Figur 7 gezeigten Sicherungselemente 30 mittels Stromschienen 35, 36 verbunden und begrenzen einen Stromfluss eingangsseitig von den Anschlusskontakten 100, 101, 102, die an der Vorderseite des zweiten Einspeisemoduls 1 angeordnet sind, zu den rückseitig angeordneten Anschlusskontakten 120, 121, 122 ausgangsseitig zu dem Antriebsmodul 11.

Selbstverständlich ist es auch möglich, den in Figur 8 dargestellen Lüfter 90 in einem ersten Einspeisemodul 10 anzuordnen, sofern eine zusätzliche Kühlung der Bauelemente, insbesondere der Sicherungselemente erforderlich sein sollte.

## Patentansprüche

1. Einspeisemodul (10) zum Einspeisen von elektrischem Strom in ein Antriebsmodul (11),
mit einem Gehäuse (53) mit einer Vorderseite und einer Rückseite,
mit einem an der Rückseite angeordneten ersten Anschlusskontakt und einem an der Vorderseite angeordneten zweiten Anschlusskontakt, wobei der erste Anschlusskontakt (120, 121, 122) auf einer ersten Leiterkarte (20) angeordnet ist und ausgelegt ist, das Einspeisemodul (10) mit dem Antriebsmodul (11) zu verbinden, und der zweite Anschlusskontakt (110, 111, 112) auf einer zweiten Leiterkarte (21) angeordnet ist und ausgelegt ist, eine Verbindung zu einer Stromversorgung bereitzustellen, und
mit zumindest einem Sicherungselement (30), das im Gehäuse (53)zwischen dem ersten Anschlusskontakt und dem zweiten Anschlusskontakt angeordnet ist und mit dem ersten Anschlusskontakt (120, 121, 122) und dem zweiten Anschlusskontakt (110, 111, 112; 100, 101, 102) verbunden und ausgelegt ist, einen Stromfluss zwischen dem ersten Anschlusskontakt (120, 121, 122) und dem zweiten Anschlusskontakt (110, 111, 112) zu begrenzen,
**dadurch gekennzeichnet,**
**dass** das Sicherungselement (30) zwischen der ersten Leiterkarte (20) und der zweiten Leiterkarte (21) angeordnet ist,
**dass** der zweite Anschlusskontakt (110, 111, 112) einen Kontaktschieber (13, 14, 15) eine Kontaktbrücke (16) umfasst, wobei der Kontaktschieber (13, 14, 15) ausgelegt ist, um die Kontaktbrücke (16) seitlich aus dem Gehäuse (53) herauszuschieben, um mit der Kontaktbrücke (16) seitlich in ein Gehäuse eines weiteren Einspeisemoduls einzugreifen und ein Kontaktelement des weiteren Einspeisemoduls zu kontaktieren, und
**dass** das Gehäuse (53) einen Deckel (80) umfasst, der in einem Bereich des Sicherungselements (30) seitlich am Gehäuse (53) angeordnet ist, wobei der Deckel (80) von außen zu öffnen und wieder verschließbar ist und das Sicherungselement (30) abdeckt.

2. Einspeisemodul (10) nach Anspruch 1, **dadurch gekennzeichnet, dass** das Sicherungselement (30) mit einer Stromschiene (35, 36) verbunden ist, die mit einer der beiden Leiterkarten (20, 21) verbunden ist und eine elektrische Verbindung zu einer der beiden Leiterkarten (20, 21) bereitstellt.

3. Einspeisemodul (10) nach Anspruch 2, **dadurch gekennzeichnet, dass** die Stromschiene (35) Z-förmig ausgebildet und ausgelegt ist, eine Platte (40) mit einer der beiden Leiterkarten (20, 21) zu verbinden.

4. Einspeisemodul (10) nach Anspruch 3, **dadurch gekennzeichnet, dass** das Sicherungselement (30) einen Sicherungskörper (31, 32) und einen Sicherungshalter (33, 34) umfasst, wobei der Sicherungshalter (33, 34) an der Platte (40) befestigt und mit der Stromschiene (35, 36) verbunden ist und der Sicherungshalter (33, 34) den Sicherungskörper (31, 32) im Gehäuse (53) des Einspeisemoduls (1; 10) befestigt.

5. Einspeisemodul (10) nach einem der Ansprüche 1 bis 4, **dadurch gekennzeichnet, dass** die erste Leiterkarte (20) mit der zweiten Leiterkarte (21) mittels eines Verbindungsbolzens (45) verbunden ist.

6. Einspeisemodul (10) nach einem der Ansprüche 1 bis 5, **dadurch gekennzeichnet, dass** das Gehäuse (53) einen ersten, einen zweiten und einen dritten Gehäuseteil (50, 51, 52) umfasst, wobei der erste Gehäuseteil (50) sowohl mit dem zweiten Gehäuseteil (51) als auch mit dem dritten Gehäuseteil (52) verbindbar ist.

7. Einspeisemodul (10) nach Anspruch 6, **dadurch gekennzeichnet, dass** das zweite Gehäuseteil (51) zwischen dem ersten und dem dritten Gehäuseteil (50, 52) angeordnet ist, wobei der erste Gehäuseteil (50) einen ersten zinnenförmig ausgebildeten Bereich (72) umfasst, der dem zweiten Gehäuseteil (51) zugewandt ist, und der zweite Gehäuseteil (51) einen zweiten zinnenförmigen Bereich (71) umfasst, der derart ausgebildet ist, dass der zweite zinnenförmige Bereich (71) in den ersten zinnenförmigen Bereich (72) eingreift.

8. Einspeisemodul (10) nach einem der Ansprüche 1 bis 7, **dadurch gekennzeichnet, dass** das Gehäuse (53) eine erste Öffnung (92) und eine zweite Öffnung (91) aufweist, wobei die erste Öffnung (92) an einer Oberseite (5) des Gehäuses (53) und die zweite Öffnung (91) an einer Unterseite des Gehäuses (53) angeordnet ist, wobei die Öffnungen (91, 92) ausgelegt sind, einen Kühlluftstrom durch das Gehäuse (53) zu führen.

9. Einspeisemodul (10) nach einem der Ansprüche 1 bis 8, **dadurch gekennzeichnet, dass** in dem Einspeisemodul (1; 10) ein Lüfter (90) angeordnet ist, der ausgelegt ist, Kühlluft durch das Einspeisemodul (1; 10) zu fördern.

10. Einspeisemodul (10) nach einem der Ansprüche 1 bis 9, **dadurch gekennzeichnet, dass** das Sicherungselement (30) als Schmelzsicherung oder elektronische Sicherung oder selbstrückstellende Sicherung oder Leistungsschutzschalter oder Motorschutzschalter ausgebildet ist.

## Claims

1. Feed module (10) for feeding an electric current into a drive module (11),
having a housing (53) with a front face and a rear face, having a first connection contact which is arranged on the rear face, and having a second connection contact which is arranged on the front face, wherein the first connection contact (120, 121, 122) is arranged on a first printed circuit card (20) and is designed to connect the feed module (10) to the drive module (11), and the second connection contact (110, 111, 112) is arranged on a second printed circuit card (21) and is designed to provide a connection to a power supply, and
having at least one fuse element (30) which is arranged in the housing (53) between the first connection contact and the second connection contact and is connected to the first connection contact (120, 121, 122) and to the second connection contact (110, 111, 112; 100, 101, 102) and is designed to limit a flow of current between the first connection contact (120, 121, 122) and the second connection contact (110, 111, 112),
**characterized**
**in that** the fuse element (30) is arranged between the first printed circuit card (20) and the second printed circuit card (21),
**in that** the second connection contact (110, 111, 112) comprises a contact slide and a contact bridge (16), wherein the contact slide (13, 14, 15) is designed to push the contact bridge (16) laterally out of the housing (53) in order to engage laterally into a housing of a further feed module by way of the contact bridge (16) and to make contact with a contact element of the further feed module, and
**in that** the housing (53) comprises a cover (80) which is arranged in a region of the fuse element (30) laterally on the housing (53), wherein the cover (80) is to be opened from the outside and can be closed again and covers the fuse element (30).

2. Feed module (10) according to Claim 1, **characterized in that** the fuse element (30) is connected to a busbar (35, 36) which is connected to one of the two printed circuit cards (20, 21) and provides an electrical connection to one of the two printed circuit cards (20, 21).

3. Feed module (10) according to Claim 2, **characterized in that** the busbar (35) is Z-shaped and is designed to connect a plate (40) to one of the two printed circuit cards (20, 21).

4. Feed module (10) according to Claim 3, **characterized in that** the fuse element (30) comprises a fuse body (31, 32) and a fuse holder (33, 34), wherein the fuse holder (33, 34) is fastened to the plate (40) and is connected to the busbar (35, 36), and the fuse holder (33, 34) fastens the fuse body (31, 32) in the housing (53) of the feed module (1; 10).

5. Feed module (10) according to one of Claims 1 to 4, **characterized in that** the first printed circuit card (20) is connected to the second printed circuit card (21) by means of a connecting pin (45).

6. Feed module (10) according to one of Claims 1 to 5, **characterized in that** the housing (53) comprises a first, a second and a third housing part,(50, 51, 52), wherein the first housing part (50) can be connected both to the second housing part (51) and to the third housing part (52).

7. Feed module (10) according to Claim 6, **characterized in that** the second housing part (51) is arranged between the first and the third housing part (50, 52), wherein the first housing part (50) comprises a first crenellated region (72) which faces the second housing part (51), and the second housing part (51) comprises a second crenellated region (71) which is designed in such a way that the second crenellated region (71) engages into the first crenellated region (72).

8. Feed module (10) according to one of Claims 1 to 7, **characterized in that** the housing (53) has a first opening (92) and a second opening (91), wherein the first opening (92) is arranged on a top face (5) of the housing (53), and the second opening (91) is arranged on a bottom face of the housing (53), wherein the openings (91, 92) are designed to guide a stream of cooling air through the housing (53).

9. Feed module (10) according to one of Claims 1 to 8, **characterized in that** a fan (90) is arranged in the feed module (1; 10), the said fan being designed to convey cooling air through the feed module (1; 10).

10. Feed module (10) according to one of Claims 1 to 9, **characterized in that** the fuse element (30) is in the form of a fusible link or electronic fuse or self-resetting fuse or circuit breaker or motor protection switch.

## Revendications

1. Module d'alimentation (10) destiné à alimenter en courant électrique un module d'entraînement (11), comportant un boîtier (53) ayant une face avant et une face arrière,
comportant un premier contact de raccordement disposé sur la face arrière et un deuxième contact de raccordement disposé sur la face avant, dans lequel le premier contact de raccordement (120, 121, 122) est disposé sur une première carte de circuit imprimé (20) et est conçu pour connecter le module d'alimentation (10) au module d'entraînement (11) et le deuxième contact de raccordement (110, 111, 112) est disposé sur une deuxième carte de circuit imprimé (21) et est conçu pour établir une connexion à une alimentation en courant, et
comportant au moins un élément coupe-circuit (30) qui est disposé dans le boîtier (53) entre le premier contact de raccordement et le deuxième contact de raccordement et est connecté au premier contact de raccordement (120, 121, 122) et au deuxième contact de raccordement (110, 111, 112 ; 100, 101, 102) et est conçu pour limiter un courant passant entre le premier contact de raccordement (120, 121, 122) et le deuxième contact de raccordement (110, 111, 112),
**caractérisé en ce que** l'élément coupe-circuit (30) est disposé entre la première carte de circuit imprimé (20) et la deuxième carte de circuit imprimé (21),
**en ce que** le deuxième contact de raccordement (110, 111, 112) comprend un curseur de contact ou un pont de contact (16), dans lequel le curseur de contact (13, 14, 15) est conçu pour faire coulisser latéralement le pont de contact (16) afin de le faire sortir du boîtier (53), afin qu'il vienne en prise latéralement avec le pont de contact (16) dans un boîtier d'un autre module d'alimentation et qu'il vienne en contact avec un élément de contact de l'autre module d'alimentation, et **en ce que** le boîtier (53) comprend un couvercle (80) qui est disposé latéralement sur le boîtier (53) dans une région de l'élément coupe-circuit (30), dans lequel le couvercle (80) peut être ouvert de l'extérieur et être refermé et couvre l'élément coupe-circuit (30).

2. Module d'alimentation (10) selon la revendication 1, **caractérisé en ce que** l'élément coupe-circuit (30) est connecté à une barre omnibus (35, 36) qui est connectée à l'une des cartes de circuit imprimé (20, 21) et établit une connexion électrique à l'une des deux cartes de circuit imprimé (20, 21).

3. Module d'alimentation (10) selon la revendication 2, **caractérisé en ce que** la barre omnibus (35) est réalisée de manière à présenter la forme d'un Z et est conçue pour connecter une plaquette (40) à l'une des deux cartes de circuit imprimé (20, 21).

4. Module d'alimentation (10) selon la revendication 3, **caractérisé en ce que** l'élément coupe-circuit (30) comprend un corps de coupe-circuit (31, 32) et un support de coupe-circuit (33, 34), dans lequel le support de coupe-circuit (33, 34) est fixé à la plaquette (40) et est connecté à la barre omnibus (35, 36) et **en ce que** le support de coupe-circuit (33, 34) fixe le corps de coupe-circuit (31, 32) dans le boîtier (53) du module d'alimentation (1 ; 10).

5. Module d'alimentation (10) selon l'une quelconque des revendications 1 à 4, **caractérisé en ce que** la première carte de circuit imprimé (20) est connectée à la deuxième carte de circuit imprimé (21) au moyen d'un boulon de connexion (45).

6. Module d'alimentation (10) selon l'une quelconque des revendications 1 à 5, **caractérisé en ce que** le boîtier (53) comprend des première, deuxième et troisième parties de boîtier (50, 51, 52), dans lequel la première partie de boîtier (50) peut aussi bien être connectée à la deuxième partie de boîtier (51) qu' à la troisième partie de boîtier (52).

7. Module d'alimentation (10) selon la revendication 6, **caractérisé en ce que** la deuxième partie de boîtier (51) est disposée entre les première et troisième parties de boîtier (50, 52), dans lequel la première partie de boîtier (50) comprend une première région (72) réalisée de manière crénelée qui est tournée vers la deuxième partie de boîtier (51), et la deuxième partie de boîtier (51) comprend une deuxième région crénelée (71) qui est réalisée de manière à ce que la deuxième région crénelée (71) vienne en prise dans la première région crénelée (72).

8. Module d'alimentation (10) selon l'une quelconque des revendications 1 à 7, **caractérisé en ce que** le boîtier (53) présente une première ouverture (92) et une deuxième ouverture (91), dans lequel la première ouverture (92) est disposée sur une face supérieure (5) du boîtier (53) et la deuxième ouverture (91) est disposée sur une face inférieure du boîtier (53), dans lequel les ouvertures (91, 92) sont conçues de manière à faire passer un courant d'air de refroidissement à travers le boîtier (53).

9. Module d'alimentation (10) selon l'une quelconque des revendications 1 à 8, **caractérisé en ce qu'**un ventilateur (90) est disposé dans le module d'alimentation (1 ; 10), celui-ci étant conçu pour entraîner de l'air de refroidissement à travers le module d'alimentation (1 ; 10).

10. Module d'alimentation (10) selon l'une quelconque des revendications 1 à 9, **caractérisé en ce que** l'élément coupe-circuit (30) est réalisé sous la forme d'un coupe-circuit à fusibles ou d'un coupe-circuit électronique ou d'un coupe-circuit autoréarmable ou d'un disjoncteur de puissance ou d'un disjoncteur protecteur de moteur.
